Europäisches Patentamt

(19) European Patent Office

Office européen des brevets

(11) Publication number: **0 217 512 B1**

(12) **EUROPEAN PATENT SPECIFICATION**

(45) Date of publication of the patent specification: 07.02.90

(51) Int. Cl. ⁵: **H 01 B 1/22,** H 01 B 1/24, H 01 B 1/20

(21) Application number: **86306198.2**

(22) Date of filing: **11.08.86**

(54) Polymer thick film inks.

(30) Priority: **12.08.85 US 764894**

(43) Date of publication of application: **08.04.87 Bulletin 87/15**

(45) Publication of the grant of the patent: **07.02.90 Bulletin 90/06**

(84) Designated Contracting States: **AT BE CH DE FR GB IT LI NL SE**

(56) References cited:
EP-A-0 074 281
EP-A-0 158 410
FR-A-2 098 273
FR-A-2 419 570

(73) Proprietor: **RAYCHEM CORPORATION (a Delaware corporation)**
**300 Constitution Drive**
**Menlo Park, California 94025 (US)**

(72) Inventor: **Batliwalla, Neville**
**221, Beach Park Blvd**
**Foster City California (US)**
Inventor: **McCarty, Gordon**
**2244, Belthorn Court**
**San Jose California (US)**
Inventor: **Oswal, Ravi**
**4832 La Habra Street**
**Union City, California 94587 (US)**
Inventor: **Shafe, Jeff**
**3323, Spring Street**
**Redwood City California (US)**

(74) Representative: **Auckland, Jacqueline**
**Raychem Limited Intellectual Property Law Department**
**Faraday Road Dorcan**
**Swindon, Wiltshire SN3 5HH (GB)**

**Description**

This invention relates to electrically conductive polymer thick film inks, which are commonly referred to as PTF inks.

PTF ink typically comprises an organic polymer (often referred to as a binder), a solvent in which the polymer is dissolved, and a particulate conductive filler which is dispersed in the solution of the polymer in the solvent. The ink is applied to a substrate, typically by screen printing, at room temperature, and is then heated to vaporize the solvent and cure the polymer, the term "cure" being used herein to denote any solidification of the polymer, whether or not it is accompanied by chemical reaction. A serious limitation of such PTF inks is that the polymer therein must be soluble at room temperature in a solvent which also meets other requirements such as lack of toxicity and acceptable cost. For example, no PTF ink containing polyvinylidene fluoride as binder has yet been prepared.

We have now discovered that excellent PTF inks can be prepared through the use of a "latent solvent" for the binder polymer, i. e. a solvent which does not dissolve the polymer at the printing temperature but which will dissolve the polymer at some higher temperature. At the time the ink is printed on the substrate, the binder polymer is present in the form of solid particles dispersed in the solvent.

In one aspect, the present invention provides a PTF ink which comprises (a) an organic polymer, (b) an organic solvent for the polymer, and (c) an electrically conductive filler, the polymer and the solvent being such that (i) at 20°C the polymer is in the form of solid particles dispersed in the solvent, and (ii) there is a temperature above 20°C at which the polymer is dissolved in the solvent.

In a second aspect, the invention provides a method of forming a conductive layer on a substrate which comprises

(1) printing onto the substrate a PTF ink as defined above while the polymer is in the form of solid particles dispersed in the solvent, and

(2) increasing the temperature of the printed ink first to dissolve the polymer particles in the solvent, and then to vaporize the solvent and cure the polymer.

The binder polymer can be of any kind, e. g. a polyolefin or a fluoropolymer, but the invention is particularly useful for polymers which are difficult or impossible to formulate as conventional PTF inks, for example fluoropolymers having at least 5 % crystallinity, in particular polyvinylidene fluoride. It is preferred to use a single binder polymer, but it is also possible to use a mixture of polymers, at least one of the polymers being present in the ink, as it is printed, in the form of solid particles dispersed in the solvent.

The latent solvent must be an organic liquid which meets the criteria set out above. Examples of suitable solvents are isophorone, which is preferred, cyclohexanone, butyrolactone and carbitol acetate. It is preferred to use a single solvent, but a mixture of solvents can be used.

The term "solvation temperation" (also referred to herein as $T_s$) is used herein to denote the temperature determined by the following procedure. At 20°C, a dispersion of the polymer in the latent solvent is prepared by dispersing 5 % by weight (based on the total weight of the dispersion) of the finely divided polymer in the latent solvent. Then the dispersion is heated at a rate of 5°C per minute, stirring continuously. The temperature at which the solution becomes clear is the $T_s$ of that polymer/solvent combination.

The amount and nature of the conductive filler are selected to give an ink of the desired characteristics. For more conductive inks, e. g. of resistivity $1 \times 10^{-5}$ to $1 \times 10^{-2}$ ohm.cm, preferably $1 \times 10^{-4}$ to $1 \times 10^{-3}$ ohm.cm, a conductive filler comprising silver, e. g. a mixture of silver and graphite, is preferred. [Ink resistivities given herein refer to the resistivity of the ink at 20°C after it has been cured.] Such inks are useful, for example, as electrodes printed on the surface of a resistive heating element, as disclosed for example in European Patent Publication No. 0 158 410 (corresponding to USSN 573099, MP0897). For more resistive inks, e. g. of resistivity at least 0.005 ohm.cm, e. g. 0.005 to 10 ohm.cm, a conductive filler comprising carbon black, e. g. a mixture of carbon black and graphite, is preferred. Such inks are useful for example as a layer between an electrode and a resistive heating element, as disclosed for example in European Patent Publication No. 0 176 284 (corresponding to USSN 735408, MP0961).

The substrate may be rigid or flexible, and the surface to which the ink is applied may be composed of any suitable material, including for example, a composition compring an organic polymer, e. g. a crystalline polymer; particularly good results are obtained when the substrate surface comprises a polymer which is compatible with, especially the same as, the binder polymer of the ink. In a preferred embodiment, the polymeric substrate surface is composed of a conductive polymer (i. e. a dispersion of at least one particulate conductive filler in at least one polymer), in particular a laminar resistive heating element which is melt-extruded or otherwise deposited on a support member, as disclosed for example in the publications referred to above and the patents referred to therein. The conductive polymer may for example have a resistivity of 0.5 to 100 000, particuarly 50 to 10 000, ohm.cm. We have obtained particularly good results by printing an ink in which the binder polymer comprises polyvinylidene fluoride onto a resistive element composed of a conductive polymer in which the polymer comprises polyvinylidene fluoride.

To apply the ink to a substrate, the ink is first printed onto the substrate, preferably by screen printing and preferably at room temperature (eg. 20°C). The printed ink is heated to dissolve the binder in the solvent, and then to vaporize the solvent and cure the binder. The ink is preferably heated up to, and held at, a predetermined temperature, which is hereinafter referred to as the "cure" temperature, $T_c$. $T_c$ is preferably at least 15°C above, more preferably at least 30°C above, the Ts of the binder in the solvent, and must of course be lower than the melting point of the substrate. When the substrate is a polymeric substrate, its melting point, $T_m$, is defined herein as the peak of the DSC (differential scanning calorimeter) curve. $T_c$ is preferably about equal to the temperature of the onset of melting on the same curve. In addition, when the boiling point of the solvent is less than the melting point of the substrate, $T_c$ is preferably at least 10°C lower than, more preferably at least 30°C lower than, the boiling point of the solvent, to avoid trapping of solvent within a cured "skin" of the ink.

In a preferred embodiment of the invention, an ink containing polyvinylidene fluoride as the binder and isophorone as the solvent is applied to a substrate comprising polyvinylidene fluoride. In that case $T_s$ is 100°C, the temperature of the onset of melting is 135°C, $T_m$ is 165°C, and the boiling point of isophorone is 215°C. $T_c$ is preferably about 135°C, e. g. 125 to 145°C.

As explained in the application corresponding to US Serial No. 735 409 (European Patent Application No. 86303772.2, MP1062), when a heater is made by printing PTF ink electrodes onto a laminar conductive polymer heating element, substantial advantages can be obtained by covering the electrodes and the heating element with an adherent layer of a dielectric, e. g. a polysiloxane. That measure is preferably used in the present invention also.

The invention is illustrated by the following Examples.

## Examples 1 - 9

In these Examples, which are summarized in Table 1 below, heaters were made and tested in the same way using eight commercially available PTF inks (Examples 1 - 8) and one PTF ink of the invention. (Example 9), which comprised carbon black and polyvinylidene fluoride dispersed in isophorone. The heaters were made by a process comprising printing each of the inks onto the surface of a planar heating element composed of a dispersion of carbon black in polyvinylidene fluoride, to form interdigitated electrodes, followed by heating to cure the ink, generally as described in European Patent Publication No. 0 158 410. The initial resistance of the heater at 20°C was measured, using a voltage of 100 volts. The heater was then aged by placing the heater in an oven maintained at 107°C while the heater was connected to a 240 volt AC power supply for 1 000 hours. The resistance of the aged heater at 20°C was measured, first using a voltage of 100 volts and then using a voltage of 30 millivolts.

The ratio of the resistance of the aged heater at 100 volts to the initial resistance at 100 volts (which ideally should be 1) was calculated and is recorded in Table 1 as $R_n$. The Linearity Ratio of the heater, i. e. the ratio of the resistance of the aged heater at 30 millivolts to the resistance of the aged heater at 100 volts (which ideally should be 1) was calculated and is recorded in Table 1 as LR.

### Table 1

| Ex. No. | Trade Designation | Manufacturer | Binder Polymer | $R_n$ | LR |
|---------|-------------------|--------------|----------------|-------|-----|
| 1 | 5524228 | Acheson | Urethane | >20 | >18 |
| 2 | 41755 | Acheson | Acrylic/Vinyl | >20 | >36 |
| 3 | 5030 - 7 | Amican | Epoxy | >20 | >40 |
| 4 | 1111 - S | ESL | Epoxy | 2.10 | 1.102 |
| 5 | SS24302 | Acheson | Viton® | 1.95 | 2.69 |
| 6 | 504 - SS | Acheson | Viton® | 2.00 | 1.026 |
| 7 | 426 - SS | Acheson | Polyester/Vinyl | 2.01 | 1.087 |
| 8 | SS24360 | Acheson | Vinyl | 1.39 | 1.003 |
| 9 | - | - | $PVF_2$ | 1.20 | 1.002 |

The term "vinyl" is used in Table 1 to denote a blend of polyvinyl chloride and polyvinyl acetate, typically a blend of 95 % by weight of polyvinyl chloride and 5 % by weight of polyvinyl acetate.

## Examples 10 - 11

The procedure of Examples 8 and 9 was followed except that before the ageing treatment, the electrodes and the heating element on which they were printed were covered by a layer of a polysiloxane dielectric, as generally disclosed in the application corresponding to US Serial No. 735 409 (European Patent Application No. 86303772.2, MP1062). After ageing, the Linearity Ratio of the comparative heater (made using Acheson® SS 24360 PTF ink) was 1.036, and the Linearity Ratio of the heater of the invention was 1.003.

# EP 0 217 512 B1

**Examples 12 - 13**

Polymer thick film inks were prepared from the ingredients and amounts thereof (in parts by weight) shown in Table 2 below. The polyvinylidene fluoride used was Kynar® 461 supplied by Pennwalt USA; the silver flake was Silver Flake® 11401 supplied by Aesar, Johnson Mathey USA; the graphite was Graphite® 870 supplied by Ashbury Graphite; the carbon black was Carbon Black® XC - 72 supplied by Cabot; and the fumed silica was Cab-O-Sil® supplied by Cabot.

**Table 2**

| Ingredients | Example 12 | Example 13 |
| --- | --- | --- |
| Polyvinylidene fluoride | 19.3 | 14.5 |
| Silver flake | 43.1 | - |
| Graphite | 6.3 | 32.9 |
| Carbon Black | 1.8 | 2.2 |
| Fumed Silica | 1.8 | 0.7 |
| Isophorone | 27.7 | 49.7 |

The method used to mix the ingredients was as follows.

To a mixture of the carbon black and graphite, 80 % of the isophorone was added, and mixed to a paste. The silver (Example 1 only), the polyvinylidene fluoride powder, and two thirds of the fumed silica were added sequentially, stirring well between each addition. If the paste became too thick, additional isophorone is added. The blend was placed in a 3-roll paint mill in which there was a 28mm gap between the feed and outer rollers, and in which there was no contact between the take-off and central rollers. The remaining fumed silica was added to the mill and the blend milled for 45 minutes. Finally the ink was removed from the mill by adjusting the position of the take-off roller, and additional solvent added, if required, to give the required viscosity for screen printing.

After screen printing onto a substrate, followed by heating to dissolve the polyvinylidene fluoride in the isophorone, vaporize the solvent and cure the ink, the ink of Example 1 had a resistivity of 0.001 ohm.cm and the ink of Example 2 had a resistivity of 0.2 ohm.cm.

**Claims:**

1. A polymer thick film ink which comprises
   a) an organic polymer,
   b) an organic solvent for the polymer, and
   c) an electrically conductive particulate filler; characterized in that
      (i) at 20°C the polymer is in the form of solid particles dispersed in the solvent, and
      (ii) there is a temperature above 20°C at which the polymer is dissolved in the solvent.

2. An ink according to claim 1, characterized in that the polymer is a fluorinated polymer having a crystallinity of at least 5 %, preferably polyvinylidene fluoride.

3. An ink according to claim 1 or 2, characterized in that the solvent is cyclohexanone, butyrolactone, isophorone, or carbitol acetate.

4. An ink according to any one of the preceding claims characterized in that the solvent wets the polymer at room temperature.

5. A method of forming a conductive layer on substrate characterized by
   (1) printing onto the substrate a polymer thick film ink as claimed in any one of claims 1 to 4 while the organic polymer is in the form of solid particles dispersed in the solvent, and
   (2) increasing the temperature of the printed ink first to dissolve the polymer particles in the solvent, and then to vaporize the solvent and cure the polymer.

6. A method according to claim 5 characterized in that the ink is printed at room temperature.

7. A method according to claim 5 or 6 characterized in that in step (2) the temperature is (a) increased to a temperature which is (i) at least 15°C above, preferably at least 30°C above, the solvation temperature $T_s$ of the polymer in the solvent (as hereinbefore defined), and (ii) at least 10°C lower, preferably at least 30°C lower, than the boiling point of the solvent, and (b) is held at that temperature to vaporize the solvent and cure the polymer.

8. A method according to any one of claims 5, 6 and 7 characterized in that the surface of the substrate onto which the

4

ink is printed comprises a crystalline polymer, and in step (2) the temperature is increased to a temperature which is substantially the same as the temperature of the onset of melting of the substrate surface.

9. A method according to claim 8 wherein the polymer of the ink and the polymer of the substrate surface are the same, preferably polyvinylidene fluoride.

10. A method according to any one of claims 5 to 9 characterized in that (i) the surface of the substrate onto which the ink is printed comprises a conductive polymer having a resistivity at 20°C of 50 to 10 000 ohm.cm and (ii) the ink, after step (2), has a resistivity which is less than the resistivity of the conductive polymer and is from 0.005 to 10 ohm.cm.

## Patentansprüche

1. Polymere Dickfilmtinte, welche
   a) ein organisches Polymer
   b) ein organisches Lösungsmittel für das Polymer, und
   c) einen elektrisch leitenden in Partikelform vorliegender Füller umfaßt, *dadurch gekennzeichnet*, daß
      (i) das Polymer bei 20°C in Form von festen Partikeln im Lösungsmittel dispergiert ist und
      (ii) das Polymer bei einer Temperatur, die über 20°C liegt, in dem Lösungsmittel gelöst ist.

2. Tinte nach Anspruch 1, *dadurch gekennzeichnet*, daß das Polymer ein fluoriertes Polymer mit einer Kristallinität von mindestens 5 %, vorzugsweise Polyvinylidenfluorid, ist.

3. Tinte nach Anspruch 1 oder 2, *dadurch gekennzeichnet*, daß das Lösungsmittel Cyclohexanon, Butyrolacton, Isophoron oder Carbitolacetat ist.

4. Tinte nach einem der vorangehenden Ansprüche, *dadurch gekennzeichnet*, daß das Lösungsmittel das Polymer bei Raumtemperatur benetzt.

5. Verfahren zur Herstellung einer leitenden Schicht auf einem Substrat, *gekennzeichnet durch*
   (1) Aufdrucken einer polymeren Dickfilmtinte nach einem der Ansprüche 1 bis 4 auf das Substrat, während das organische Polymer in Form fester Partikel im Lösungsmittel dispergiert ist, und
   (2) Erhöhen der Temperatur der aufgedruckten Tinte, um zunächst die Polymer-Partikel in dem Lösungsmittel zu lösen, und um dann das Lösungsmittel zu verdampfen und das Polymer zu härten.

6. Verfahren nach Anspruch 5, *dadurch gekennzeichnet*, daß die Tinte bei Raumtemperatur aufgedruckt wird.

7. Verfahren nach Anspruch 5 oder 6, *dadurch gekennzeichnet*, daß bei Stufe (2) die Temperatur (a) erhöht wird auf eine Temperatur, die (i) mindestens 15°C oberhalb, vorzugsweise 30°C über der Lösungstemperatur $T_s$ des Polymer im Lösungsmittel (wie oben definiert), und (ii) mindestens 10°C unterhalb, vorzugsweise mindestens 30°C unterhalb des Siedepunktes des Lösungsmittels liegt, und (b) bei jener Temperatur gehalten wird, um das Lösungsmittel zu verdampfen und das Polymer zu härten.

8. Verfahren nach einem der Ansprüche 5, 6 und 7, *dadurch gekennzeichnet*, daß die Oberfläche des Substrates, auf welche die Tinte aufgedruckt wird, ein kristallines Polymer umfaßt, und bei Stufe (2) die Temperatur auf eine Temperatur erhöht wird, die im wesentlichen die gleiche ist, wie die Temperatur, bei der die Substratoberfläche zu schmelzen beginnt.

9. Verfahren nach Anspruch 8, wobei das Polymer der Tinte und das Polymer der Substratoberfläche gleich sind, vorzugsweise Polyvinylidenfluorid.

10. Verfahren nach einem der Ansprüche 5 bis 9, *dadurch gekennzeichnet*, daß (i) die Oberfläche des Substrates, auf das die Tinte aufgedruckt wird, ein leitendes Polymer mit einem spezifischen Widerstand von 50 bis 10.000 Ohm.cm bei 20°C und (ii) die Tinte, nach Stufe (2), einen spezifischen Widerstand aufweist, der kleiner ist als der spezifische Widerstand des leitenden Polymer, und zwar 0,005 bis 10 Ohm.cm beträgt.

## Revendications

1. Encre pour film polymère épais qui comprend
   a) un polymère organique,
   b) un solvant organique pour le polymère, et
   c) une charge particulaire conductrice de l'électricité, caractérisée en ce que
      (i) à 20°C le polymère est sous forme de particules solides en dispersion au sein du solvant, et
      (ii) il existe une température supérieure à 20°C à laquelle le polymère se dissout dans le solvant.

5

2. Encre selon la revendication 1, caractérisée en ce que le polymère est un polymère fluoré ayant un degré de cristallinité d'au moins 5 %, de préférence du poly(fluorure de vinylidène).

3. Encre selon les revendications 1 ou 2, caractérisée en ce que le solvant est la cyclohexanone, la butyrolactone, l'isophorone ou l'acétate de carbitol.

4. Encre selon l'une quelconque des revendications précédentes, caractérisée en ce que le solvant imprègne le polymère à température ambiante.

5. Procédé pour former une couche conductrice sur un substrat caractérisé par le fait de:
   (1) imprimer sur le substrat une encre pour film polymère épais telle que revendiquée dans l'une quelconque des revendications 1 à 4 alors que le polymère organique est sous forme de particules solides en dispersion au sein du solvant, et
   (2) augmenter la température de l'encre imprimée d'abord pour dissoudre les particules de polymère dans le solvant, et ensuite pour évaporer le solvant et durcir le polymère.

6. Procédé selon la revendication 5, caractérisé en ce que l'encre est imprimée à température ambiante.

7. Procédé selon les revendications 5 ou 6, caractérisé en ce que, au stade (2), la température est (a) augmentée jusqu'à une température qui est (i) d'au moins 15°C au-dessus, de préférence au moins 30°C au-dessus, de la température de solvatation Ts du polymère dans le solvant (comme défini ci-dessus), et (ii) d'au moins 10°C inférieure, de préférence 30°C inférieure, au point d'ébullition du solvant, et (b) maintenue à cette température pour évaporer le solvant et durcir le polymère.

8. Procédé selon l'une quelconque des revendications 5, 6 et 7, caractérisé en ce que la surface du substrat sur lequel on imprime l'encre, comprend un polymère cristallin, et en ce qu'au stade (2), on augmente la température jusqu'à une température qui est pratiquement la même que celle de début de fusion de la surface du substrat.

9. Procédé selon la revendication 8, dans lequel le polymère de l'encre et le polymère de la surface du substrat sont les mêmes, de préférence: le poly(fluorure de vinylidène).

10. Procédé selon l'une quelconque des revendications 5 à 9, caractérisé en ce que (i) la surface du substrat sur lequel on imprime l'encre, comprend un polymère conducteur ayant une résistivité à 20°C de 50 à 10.000 ohm.cm, et (ii) l'encre, après le stade (2), possède une résistivité qui est inférieure à la résistivité du polymère conducteur et est de l'ordre de 0,005 à 10 ohm.cm.